Europäisches Patentamt

European Patent Office

Office européen des brevets

(19)

(11) EP 0 450 223 B1

(12) **EUROPEAN PATENT SPECIFICATION**

(45) Date of publication and mention
of the grant of the patent:
**20.03.1996 Bulletin 1996/12**

(51) Int Cl.6: **H01L 23/495**

(21) Application number: **90309862.2**

(22) Date of filing: **10.09.1990**

(54) **Lead frames for semiconductor resin packages**

Anschlussrahmen für Harz-Halbleiterverpackungen

Cadre conducteur pour empaquetage d'un semi-conducteur par résine

(84) Designated Contracting States:
**CH DE FR GB LI NL**

(30) Priority: **06.04.1990 JP 92553/90**
            **06.04.1990 JP 92554/90**

(43) Date of publication of application:
**09.10.1991 Bulletin 1991/41**

(73) Proprietor: **SUMITOMO SPECIAL METAL CO.,
LTD.
Osaka City, Osaka (JP)**

(72) Inventors:
• **Nakamura, Yasuyuki, c/o Suita Seisakusho of
Minamisuita, Suita City, Osaka (JP)**

• **Nemoto, Shin, c/o Suita Seisakusho of
Minamisuita, Suita City, Osaka (JP)**

(74) Representative:
**Livsey, Gilbert Charlesworth Norris et al
HYDE, HEIDE & O'DONNELL
10-12 Priest's Bridge
London SW15 5JE (GB)**

(56) References cited:
**EP-A- 0 392 109          DE-A- 3 144 759**

• **PATENT ABSTRACTS OF JAPAN vol. 013, no.
268 (E-775) 20 June 1989, & JP-A- 01 059844**
• **PATENT ABSTRACTS OF JAPAN vol. 006, no.
193 (M-160) 02 October 1982& JP-A-57 100887**
• **PATENT ABSTRACTS OF JAPAN vol. 010, no.
104 (E-397) 19 April 1986, & JP-A- 60 242653 (**
• **PATENT ABSTRACTS OF JAPAN vol. 010, no.
121 (E-401) 07 May 1986, & JP-A- 60 254759**

**Description**

LEAD FRAMES FOR SEMICONDUCTOR RESIN PACKAGES

The present invention concerns resin-sealed semiconductor packages in combination with Cu based lead frames.

The lead frames for semiconductor packages made of synthetic resin material have generally been made of copper alloys with good thermal conductivity, in view of the heat dissipation capacity requirement. However, for applications requiring high reliability, copper alloys are not so favourable since they do not match the thermal expansion coefficient of the chips, and there is therefore a danger of peeling at the bonding interface between the chip and the lead frame island or cracking of the chip.

Accordingly, there has been proposed a semiconductor package and lead frame combination using for the lead frame a Ni-Fe series alloy of low thermal expansion coefficient such as 42% Ni-Fe alloy, in view of the conformity of its thermal expansion coefficient to that of the chip. However, since the Ni-Fe series alloy has poor thermal conductivity, it does not give satisfactory heat dissipation. In addition, the difference of thermal expansion between the chip and the sealing resin is extremely large. Accordingly, even if the thermal expansion coefficients of the lead frame and the chip are matched, there is a mismatch between the lead frame and the resin, so that it is difficult to completely prevent cracking in the sealing resin.

Integrated circuit chips (hereinafter referred to as "chips") of semiconductor packages, and especially LSI or VLSI chips for large-scale computers, are attaining a high degree of integration and increased operation speed. The quantity of heat generated by the operation of the devices has thus become extremely large, because of the large amount of the electric power consumed by their operation.

As a result, if the thermal expansion coefficient of the substrate material is significantly different from that of the material of the chip (made of silicon or gallium arsenic), there is a problem that the chip would suffer from peeling or cracking away from the substrate.

In view of the above, a high heat dissipation capacity is required in the design of semiconductor packages. To achieve this, the chip-carrying substrate must have a high heat dissipation capacity and thus a large thermal conductivity is required for the substrate material.

The main object of the present invention is to provide a lead frame which has a high heat conductivity but is subject to little or no peeling or cracking from a chip attached thereto and encapsulated in resin.

Accordingly the present invention provides a combination of a resin-sealed semiconductor package and a lead frame comprising a semiconductor chip mounted on the lead frame and resin-sealed thereon within said package, said lead frame being made of a strip of copper or copper alloy sheet and said chip being mounted on an island portion of said lead frame, said island portion having bonded only on the side of the island portion opposite to where the said chip is mounted, a metal foil with a thermal expansion coefficient that is low with respect to that of copper or said copper alloy.

Reference is made to prior proposals in earlier patent application EP-A-0 392 109; Patent Abstracts of Japan 10(121), (E-401); and DE-A-3 144 759). In these prior documents, it has been proposed to provide composites suitable as substrates for mounting semiconductor chips, the substrates comprising a sheet of high thermal expansion of eg Cu that is laminated with a sheet of low thermal expansion eg Kovar. However in these prior proposals the sheet of low thermal expansion was mounted on the same side as the chip, and this did not solve the problems of peeling and cracking.

The present invention results from various studies which the inventors have made of the bending of island portions during heating with chips mounted thereon. The purpose of these studies has been to improve the thermal bondability between a copper or copper alloy sheet of excellent heat dissipation and a chip of large capacity. It has been found that the warping, etc., during heating, of the side of the substrate on which the chip is mounted can be reduced, preventing damage to the chip such as peeling or cracking, by cladding metal foils of low thermal expansion in a spot-like pattern to the alloy sheet opposite where the semi-conductor chips are to be mounted.

This has led to our development of a lead frame material made of a strip of copper or copper alloy sheet for use in resin packages, in which semiconductor chips are mounted and resin-sealed on island portions of lead frames fabricated from a strip of substrate material by means of punching, etc, wherein the lead frame material comprises a spot-clad material in which metal foils of low thermal expansion are roll-bonded and arranged along the substrate at positions to be formed into island portions, on the side opposite where semiconductor chips are to be mounted.

Various embodiments of the invention and the manner in which they are made will now be described, by way of example, with reference to the drawings in which:-

Figure 1 shows a strip of single-sided lead frames;

Figures 2a, b and c are longitudinal sections through three varieties of single-sided lead frames;

Figures 3a, b and c are three fully resin packaged chips on single-sided lead frames;

Figure 4a shows the relationship betwen the thickness ratio of a substrate material to a cladding metal foil and the bending coefficient;

Figure 4b shows a test composite;
Figure 5 shows the relationship between temperature and the thickness ratio of the cladding metal foil to the substrate materials; and
Figure 6 is a longitudinal section view of a conventional resin package.

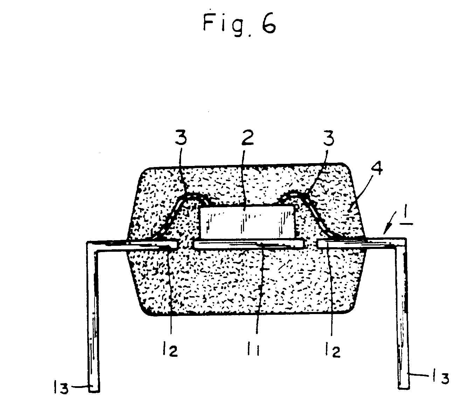

Figure 6 shows a known form of resin-sealed semiconductor package. In this, a lead frame not only serves as a path for electrically connecting a chip to the outside but also has an important role as a path for releasing the heat generated from the chip.

More specifically, in the plastic package, a chip 2 is mounted on an island $1_1$ formed by the central portion of a lead frame 1 and is fixed thereon with brazing material, adhesive, or solder. The chip 2 is also electrically connected with an inner lead $1_2$ by way of a bonding wire 3 and the assembly is sealed by means of a resin encapsulation 4.

The heat generated by the chip 2 reaches an outer lead $1_3$ of the lead frame 1 by way of a path including the island $1_1$, the resin 4, and the inner lead $1_2$, and is then released to the outside through the outer surface of the resin 4.

Accordingly, it is desirable for the lead frame 1 to be made of a material having a high thermal conductivity, so that heat generated by the chip can be efficiently released to the outside of the semiconductor package.

On the other hand, peeling of the chip 2 from the island $1_1$ occurring in the bonding interface therebetween and cracking in the resin 4 are caused by the difference of the thermal expansion coefficient of the chip 2 from that of the sealing resin 4 and the lead frame 1. To prevent such damage, conformity of the thermal expansion coefficient of the chip 2 with that of the resin 4 and the lead frame 1 is desirable.

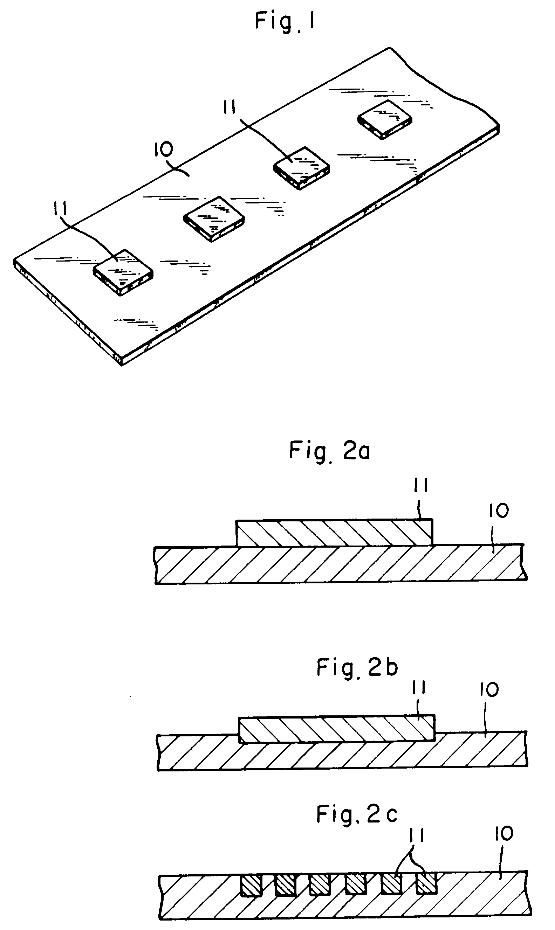

As shown in Figure 1, the lead frame material comprises a spot-clad material, in which metal foils 11 of low thermal expansion each of a predetermined size are bonded and arranged at predetermined intervals on the required side of a strip of Cu series substrate material 10 made of copper or copper alloy.

More specifically, the strip of Cu series substrate material 10 is shaped by punching into a plurality of lead frames of desired pattern. The metal foils 11 of low thermal expansion, each of a predetermined size, are roll-bonded and arranged at predetermined intervals along the length of the strip 10, forming island portions on the side opposite that on which the semiconductor chips are to be mounted.

As described later, each of the metal foils 11 of low thermal expansion has its thickness and size selected with reference to the thickness of the Cu series substrate material 10, the size of the chip to be mounted, etc.

The metal foils 11 of low thermal expansion may be roll-bonded to the surface of the Cu series substrate material 10 or partially or entirely embedded into the substrate material, as shown in Figures 2a, b and c.

Further, the metal foil 11 of low thermal expansion may be a punched metal sheet formed with a variety of shapes of apertures. In this case, since the Cu series substrate material intrudes in the apertures, the effective thermal expansion coefficient will lie between the copper or copper alloy and the metal material of low heat expansion in accordance with the volume ratio between the copper or copper alloy and the metal material of low thermal expansion.

For the Cu series substrate material 10, there can be used, in addition to pure Cu, any of known Cu alloys such as Cu-Sn, Cu-Fe, Cu-Zn, Cu-Co, Cu-Ni, Cu-Zr or Cu series alloys further including P, Cr, etc, which can be selected depending on the application, required performance, etc.

For the metal foil 11 of low thermal expansion, there can be used, in addition to Ni-Fe series alloys of various compositions such as 36Ni-Fe alloy, 3- Ni-4Co-Fe alloy, 42 Ni-Fe alloy, any of known metal materials of low thermal expansion such as so-called Kovar alloy, Mo, Fe-Cr alloy, etc.

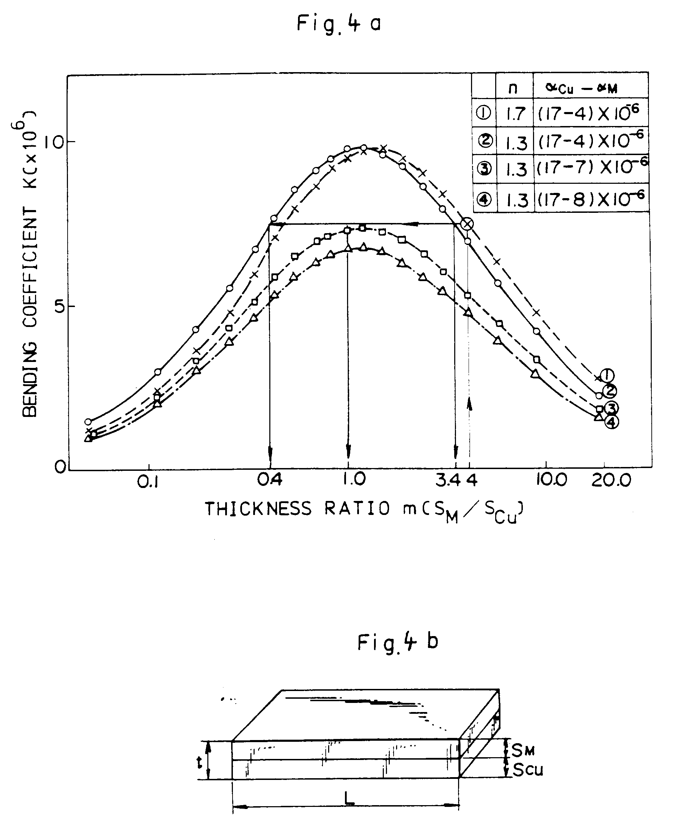

Various kinds of lead frame constructions as shown in Figures 2a, b and c may be used. A plurality of lead frames of desired pattern are shaped in the longitudinal direction, by for example punching, and resin packages are prepared from the resultant lead frames. For this, a chip 2 is placed on an island $1_1$ formed at the central portion of lead frame 1 as shown in Figures 4a, b and c. The chip 2 is fixed by means of brazing material, adhesive or solder, electrically connected with an inner lead $1_2$ by means of a bonding wire 3, and then sealed therearound with a resin 4.

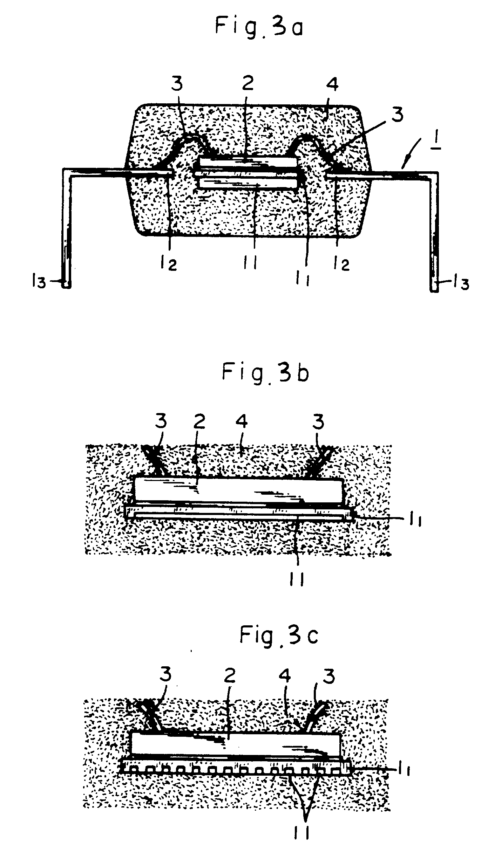

In the embodiment shown in Figure 3a, a metal foil 11 of low thermal expansion is roll-bonded to an island $1_1$ on the side opposite to that where a chip 2 is to be mounted. In Figure 3b, a metal foil 11 of low thermal expansion is entirely embedded in the surface of an island $1_1$ to be the same thickness as other portions of the lead. In Figure 3c, a metal foil 11 of low thermal expansion constituted as a punched metal sheet is embedded in the surface of an island $1_1$.

In the packages shown in Figures 3a, b and c, heat generated by the chip 2 passes by way of the path including the island $1_1$, the resin 4 and the inner lead $1_2$ to the lead $1_3$ of the lead frame 1 and is then released to the outside. Since the entire path is made of the Cu series substrate material, the heat dissipation capacity is extremely good.

Further, since the metal foil 11 of a required low thermal expansion is roll-bonded and embedded on or in the surface of the island $1_1$ opposite the chip 2, the lead frame undergoes almost no warping upon heating. Peeling, etc, at the bonding interface between the chip 2 and the island $1_1$ is thus prevented, giving a highly reliable resin package.

The lead frame of the invention, as shown in Figure 1, comprises a spot-clad material in which metal foils 11 of low thermal expansion are placed against a strip of Cu series substrate material 10 made of copper or copper alloy, and are roll-bonded and rolled to predetermined intervals. The material, thickness, and size of the metal foil 11 are selected having regard to the thickness of the Cu series substrate 10 and the size of the chip to be mounted. The specific thickness and size of the metal foil 11 of low thermal expansion are selected mainly by confirming them in an actual mounting test.

The following means can be adopted as a general standard.

The island portion of the lead frame on which the chip is to be mounted is treated as a composite material comprising the chip, and the lead frame (substrate + metal foils of low thermal expansion) parameters and conditions for not bending the composite material are determined. That is, conditions are determined such that the amounts of bending upon heating through a temperature rise ΔT are equal and opposite for the low thermal expansion materials on the two surfaces of the substrate. Since the amount of bending is proportional to the bending coefficient in the case of the composition material, the conditions in which the bending coefficients become identical can be determined.

Accordingly, the optimum thickness of the metal foils of low thermal expansion may be determined, depending on the chip to be mounted and the thickness of the Cu series substrate, by considering the relationship between the bending coefficients for the combinations of chip with substrate and substrate with metal foil of low thermal expansion, and the plate thickness ratio.

The relevant formulas are as follows:-

Bending coefficient K:

$$K = \frac{3(a_{Cu} - a_M)(1 + m)^2}{3(1 + m)^2 + (1 + mn)(m^2 + \frac{1}{mn})}$$

Bending amount D:

$$D = K\Delta TL^2/t$$

Thermal expansion coefficient $\alpha$:      $\alpha\,Cu$ = copper
     $\alpha\,M$ = metal of low thermal expansion

Plate thickness ratio m:      $m = S_M/Sc_u$

Young's modulus ratio n:      $n = E_M/E_{Cu}$
     $E_{Cu}$ = Copper
     $E_M$ = metal of low thermal expansion

Length of composite material = L,
Thickness of composite material = t.

Thus for example, referring to Figure 4a, curve (1) shows the bending coefficient of a silicon chip (thermal expansion coefficient: $4 \times 10^{-6}$) with the Cu series substrate, curve (2) shows the bending coefficient of Cu series substrate + 36Ni-Fe, and curves (3), (4) show the bending coefficients for Cu series substrate + Kovar (thermal expansion coefficient: $7-8 \times 10^{-6}$).

It can be seen that for a silicon chip of 0.4 mm thickness and Cu substrate of 0.1 mm thickness as shown in the example, the thickness of the 36 Ni-Fe material is preferably 0.34 mm or 0.04 mm and the thickness of Kovar is preferably about 0.1 mm.

As described above, metal foils of low thermal expansion of material, thickness and size are selected in the light of the kind and the thickness of the Cu series substrate, the size of the chip to be mounted, etc. These foils are stacked on the Cu series substrate, roll-bonded, and rolled till the desired thickness ratio is obtained. The metal foil of low thermal expansion is clad in a spot-like pattern along the longitudinal direction of the Cu series substrate material; its pitch and size should be of high accuracy when it is fabricated into a lead frame.

A spot-clad material having pitch and size of high accuracy can be obtained, for example, by the following procedure: (1) uncoiling and intermittently feeding a metal foil and a Cu series substrate material, each by a predetermined length; (2) applying continuous supersonic welding to the foil and substrate at predetermined intervals; (3) cutting the metal foil at predetermined intervals by a pair of rotary cutters thereby removing loose metal foil pieces; (4) seizing and cutting a metal foil which is intermittently fed by predetermined lengths by means of a punching tool and, simultaneously, spot welding them on a Cu series substrate material which is also fed intermittently at predetermined lengths using an electrode incorporated in the punching tool, or by provisionally fixing them by supersonic welding using a supersonic welding vibration plate incorporated in a punching tool; and (5) then roll-bonding and rolling them.

Alternatively, the spot-clad material can also be obtained by: (1) provisionally fixing a metal foil and a Cu series substrate material, which are each fed intermittently by predetermined lengths by means of laser welding continuously at predetermined intervals; (2) removing metal foil pieces which are not so fixed by cutting the metal foil at predetermined intervals by means of a rotary cutter or by seizing and cutting the metal foil intermittently fed by predetermined lengths and then provisionally fixing it on the Cu series substrate material which is also fed intermittently by predetermined lengths by means of laser welding while held by means of the punching tool and then (3) roll-bonding and rolling them. In this case, a high accuracy of pitch control can be attained by abutting backup rolls to a pair of work rolls of a rolling mill and providing a device for detecting the load upon pressurizing the uncoiled Cu series substrate material and a plate thickness gauge, and applying a constant load control by a rolling load controller. A quantitative relationship can be determined between the variations of the rolling load, the variations of the pitch, and the absolute position, based on the the measured value for the absolute position of the metal foil from a required original point and a control model and by calculating a target rolling load (refer to Japanese Patent Applications Hei 1-216759 and Hei 1-216760). In addition to the manufacturing method using the roll-bonding and the rolling mill as described above, the metal foil pieces can also be embedded into and arranged on the Cu series substrate material by means of a compression machine.

In a case where the metal foil 11 of low thermal expansion is bonded to the Cu series substrate material 10 by means of pin-down bonding, a similar effect for preventing bending can also be obtained. Further, in a case where the metal foil 11 of low thermal expansion is embedded in the surface of the Cu series substrate material 10 on the side reverse to the area to be formed with an island as shown in Figure 2b, the bending preventive effect can similarly be obtained by merely attaching the metal foil 11 only at its ends or edges.

Ag or Au can be plated in a strip or spot-like pattern at predetermined positions on the surface of the lead frame material on the side on which the chips are mounted; that is, the surface including the bonding area of the lead frame.

In the same way, foils of Ag, Au, Al, Cu, etc, can be roll-bonded and rolled in a strip, of pattern depending on the kind of the bonding wire, at predetermined positions on the lead frame material on the side to have chips mounted on it. The method may be adopted of applying roll-bonding and rolling after cutting the foils into foil pieces and then provisionally fixing them.

Further, when one or more strips of pure copper foils of a purity of 99.9% or higher are cold or warm rolled to a thickness of 2 to 50 $\mu$m at the positions on the surface of the lead frame including the bonding area, Cu wires can be used for the bonding. The bonding operation can be applied easily and reliably in the assembly step for the Cu alloy lead frame material of excellent heat dissipation without requiring expensive Au or Ag spot plating.

A preferred roll-bonding method includes cleaning the surface with a softened wire brush, cold bonding under pressure, applying diffusing annealing and then rolling to a required thickness. A thickness greater than 10$\mu$m is preferred in view of the fact that the surface of the pure Cu foil can maintain the property of pure Cu having a purity of 99.9% or higher and can possess satisfactory bonding property and high mechanical strength.

EXAMPLES

Example 1

A lead frame material corresponding to the first form of the invention comprising a pure Cu substrate material of size 0.2 x 36.5 x 230 mm (t x w x 1) was prepared for punching 8 lead frames for use in resin packages of 26-pin arrangement capable of mounting a chip of size 15.6 x 6.24 x 0.4 (thickness) mm.

For obtaining a construction as shown in Figure 3a in which a metal foil 11 of low thermal expansion is roll-bonded to the reverse surface of an island $1_1$, since m - $S_{Si}/S_{Cu}$ = 2, it can be seen from Figure 3a that K = 9.5, $S_M/S_{Cu}$ = m = 0.8, n = 1.33, $\alpha$ = 4 x $10^6$ and E = 15,000. Accordingly, 36Ni-Fe material with thickness of 0.16 mm or 3.4 mm is optimal for the metal foil of low thermal expansion coefficient.

36Ni-Fe material was accordingly roll-bonded and rolled to attain the above-mentioned thickness ratio at 8 positions on the pure Cu substrate material, to manufacture lead frame materials in which metal foils of low heat expansion, each sized 14.5 x 5.4 mm and having a thickness of 0.16 mm or 3.4 mm, were arranged in a spot-like manner.

Example 2

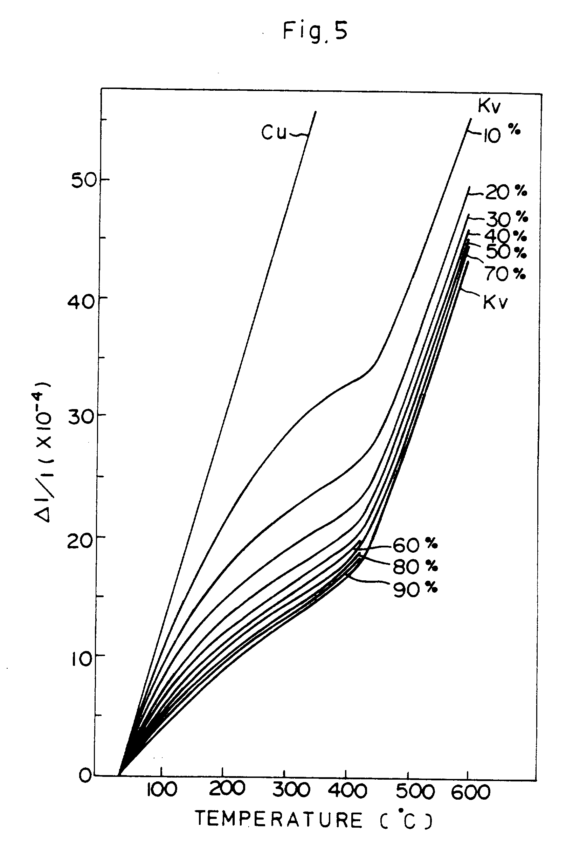

For obtaining a construction as shown, similar to that of Example 1 but in which a metal foil 11 of low thermal expansion is embedded at the inside of the island $1_1$ shown in Figure 3b so that the whole of the lead portion is of the same thickness, we take m = $S_{Si}/S_{Cu}$ = 4, and the thickness of the pure Cu substrate material as 0.1 mm. Since k = 7.5 and, accordingly, since the thickness for the island $1_1$ is 0.2 mm from Figure 5a, it can be seen that $S_M/S_{Cu}$ = m = 1, n = 1.33, $\alpha$ = 7 x $10^6$ and E = 15,000, and Kovar material of 0.1 mm thickness is optimum for the metal foil of low thermal expansion.

Kovar of the appropriate thickness was roll-bonded and rolled to attain the above-mentioned thickness ratio at 8 positions on the pure Cu substrate material, to manufacture a lead frame material in which metal foils of low heat expansion each 14.4 x 5.2 x 0.1 mm thick were arranged in a spot-like manner.

Example 3

Kovar material was formed as a punched metal sheet and was roll-bonded and rolled at 8 positions on the pure Cu substrate material so as to be embedded to a thickness of 0.1 mm as in Example 2; since the Cu substrate material filled in the punched apertures of the Kovar material upon roll-bonding, the plate shape after the roll-bonding was extremely satisfactory.

Results

When, for each of the above examples, 50 resin packages were prepared by using the lead frame material described above and subjected to the mounting test, no damage to the chips such as peeling or cracking was observed.

The lead frame constructions described above has metal foils of low thermal expansion cladding, in a spot-like pattern, the Cu series lead frame material giving excellent heat dissipation. With the metal foils of required low thermal expansion being roll-bonded and embedded in or on the island portions where chips are to be mounted, the material undergoes little or no warping upon heating. Peeling at the bonding interface between the chip and the island, etc. is thus effectively prevented, giving a highly reliable resin package.

**Claims**

1. The combination of a resin-sealed semiconductor package and a lead frame comprising a semiconductor chip mounted on the lead frame and resin-sealed thereon within said package, said lead frame being made of a strip of copper or copper alloy sheet and said chip being mounted on an island portion of said lead frame, said island portion having bonded only on the side of the island portion opposite to where the said chip is mounted, a metal foil with a thermal expansion coefficient that is low with respect to that of copper or said copper alloy.

2. The combination according to claim 1, characterised in that the metal foil is a punched metal sheet.

3. The combination according to any previous claim, characterised in that the metal foil is is a Ni-Fe series alloy.

4. The combination according to any one of claims 1 to 3, characterised in that the metal foil is a Kovar alloy.

5. The combination according to any previous claim, characterised in that the metal foil is a metal sheet having a plurality of through holes.

6. The combination according to any previous claim, characterised in that the lead frame material comprises pure Cu.

7. The combination according to any previous claim, characterised in that the copper or copper alloy sheet is plated with Ag or Au on the side on which the semiconductor chip is mounted.

8. The combination according to any one claims 1 to 6, characterised in that the copper of copper alloy sheet has a foil of Ag, Au, Al or Cu bonded on the side on which the semiconductor chip is mounted.

9. The combination according to claim 8, characterised in that the bonded foil is Cu of purity of 99.9% of a thickness of 2 to 50 µm.

**Patentansprüche**

1. Die Kombination aus einer in Harz eingekapselten Halbleiterpackung und einem Anschlußrahmen, welche einen auf dem Anschlußrahmen montierten und auf ihm in der besagten Packung in Harz eingekapselten Halbleiterchip aufweist, wobei der besagte Anschlußrahmen aus einem Streifen aus Kupfer- oder Kupferlegierungsblech besteht und der besagte Chip auf einem Inselabschnitt des besagten Anschlußrahmens montiert ist und an dem besagten Inselabschnitt nur an der Seite des Inselabschnitts, die von der Seite abgewandt ist, an der der Chip montiert ist, eine Metallfolie befestigt ist, die einen thermischen Ausdehnungskoeffizenten aufweist, der klein im Hinblick auf denjenigen von Kupfer oder der besagten Kupferlegierung ist.

**2.** Die Kombination nach Anspruch 1, dadurch gekennzeichnet, daß die Metallfolie ein gestanztes Metallblech ist.

**3.** Die Kombination nach einem der vorhergehenden Ansprüche, dadurch gekennzeichnet, daß die Metallfolie aus einer Legierung aus der Ni-Fe-Reihe besteht.

**4.** Die Kombination nach einem der Ansprüche 1 bis 3, dadurch gekennzeichnet, daß die Metallfolie aus einer Kovar-Legierung besteht.

**5.** Die Kombination nach einem der vorhergehenden Ansprüche, dadurch gekennzeichnet, daß die Metallfolie aus einem Metallblech besteht, das mehrere Durchgangslöcher besitzt.

**6.** Die Kombination nach einem der vorhergehenden Ansprüche, dadurch gekennzeichnet, daß das Material des Anschlußrahmens reines Cu umfaßt.

**7.** Die Kombination nach einem der vorhergehenden Ansprüche, dadurch gekennzeichnet, daß das Kupferoder Kupferlegierungsblech an der Seite, an welcher der Halbleiterchip montiert ist, mit Ag oder Au plattiert ist.

**8.** Die Kombination nach einem der Ansprüche 1 bis 6, dadurch gekennzeichnet, daß das Kupfer- oder Kupferlegierungsblech eine Folie aus Ag, Au, Al oder Cu aufweist, die an der Seite befestigt ist, auf welcher der Halbleiterchip montiert ist.

**9.** Die Kombination nach Anspruch 8, dadurch gekennzeichnet, daß die befestigte Folie aus Cu mit einem Reinheitsgrad von 99,9% und einer Dicke von 2-50μm besteht.

**Revendications**

**1.** La combinaison d'un boîtier de dispositif à semiconducteurs en résine moulée et d'un cadre de montage comprenant une puce de semiconducteur montée sur le cadre de montage et encapsulée dans de la résine sur le cadre de montage, à l'intérieur du boîtier, ce cadre de montage étant constitué par un ruban d'une feuille de cuivre ou d'alliage de cuivre, et la puce étant montée sur une partie de palette du cadre de montage, cette partie de palette ayant une pellicule métallique dont le coefficient de dilatation thermique est faible par rapport à celui du cuivre ou de l'alliage de cuivre, qui est fixée seulement sur la face de la partie de palette opposée à celle sur laquelle la puce est montée.

**2.** La combinaison selon la revendication 1, caractérisée en ce que la pellicule métallique est une feuille de métal poinçonnée.

**3.** La combinaison selon l'une quelconque des revendications précédentes, caractérisée en ce que la pellicule métallique consiste en un alliage de la famille Ni-Fe.

**4.** La combinaison selon l'une quelconque des revendications 1 à 3, caractérisée en ce que la pellicule métallique consiste en un alliage du type Kovar.

**5.** La combinaison selon l'une quelconque des revendications précédentes, caractérisée en ce que la pellicule métallique est une feuille de métal ayant un ensemble de trous traversants.

**6.** La combinaison selon l'une quelconque des revendications précédentes, caractérisée en ce que le matériau du cadre de montage consiste en Cu pur.

**7.** La combinaison selon l'une quelconque des revendications précédentes, caractérisée en ce que la feuille de cuivre ou d'alliage de cuivre porte un placage d'Ag ou d'Au sur la face sur laquelle la puce de semiconducteur est montée.

**8.** La combinaison selon l'une quelconque des revendications 1 à 6, caractérisée en ce que la feuille de cuivre ou d'alliage de cuivre comporte une pellicule d'Ag, d'Au, d'Al ou de Cu fixée sur la face sur laquelle la puce de semiconducteur est montée.

**9.** La combinaison selon la revendication 8, caractérisée en ce que la pellicule fixée consiste en Cu d'une pureté de 99,9%, ayant une épaisseur de 2 à 50 μm.

Fig. 1

Fig. 2a

Fig. 2b

Fig. 2c

Fig. 3a

Fig. 3b

Fig. 3c

## Fig. 4 a

## Fig. 4 b

## Fig. 5

Fig. 6